# EUROPEAN PATENT SPECIFICATION

(11) **EP 0 723 600 B1**
(45) Date of publication and mention of the grant of the patent: **07.07.1999**
(21) Application number: 94927851.9
(22) Date of filing: 27.09.1994
(51) Int. Cl.: C23C 16/32

(54) **PROCESS FOR THE PREPARATION OF SILICON CARBIDE FILMS USING SINGLE ORGANOSILICON COMPOUNDS**
VERFAHREN ZUR HERSTELLUNG VON SILIZIUMKARBID-FILMEN UNTER VERWENDUNG VON EINZELNEN SILIZIUMORGANISCHEN VERBINDUNGEN
PROCEDE PERMETTANT DE PRODUIRE DES FILMS DE CARBURE DE SILICIUM A L'AIDE D'UN SEUL COMPOSE ORGANOSILICIE

(30) Priority: 11.10.1993 KR 9321027
(43) Date of publication of application: 31.07.1996
(73) Proprietor: KOREA RESEARCH INSTITUTE OF CHEMICAL TECHNOLOGY, Daejeon, 305-343 (KR)
(72) Inventor: KIM, Yunsoo, Daejeon 305-340 (KR); BOO, Jin-Hyo, Buk-gu Incheaon 403-011 (KR); YU, Kyu-Sang, Kyungsangbuk-do 750-020 (KR); JUNG, Il Nam, Songpa-gu Seoul 138-130 (KR); YEON, Seung Ho, Mikeum-si Kyungki-do 472-140 (KR)
(74) Representative: Turi, Michael, Dipl.-Phys.
(86) International application number: KR9400129
(87) International publication number: WO9510638

(56) References cited:
- EP-A- 0 193 998
- WO-A-88/04333
- US-A- 5 053 255

## Description

### Field of the Invention

The present invention relates to a process for preparing silicon carbide(SiC) films from organosilicon compounds by employing a chemical vapor deposition method; and, more specifically, to a process for preparing silicon carbide films from organosilicon compounds having linearly bonded alternating silicon and carbon atoms by employing the chemical vapor deposition method.

### Background of the Invention

Silicon carbides, due to their unique and useful properties, have been widely used for various purposes, e.g., wear-resistant or heat-resistant coatings, and have been found to be particularly useful in manufacturing electric and electronic components, photodetectors, high temperature and high power devices, high frequency circuitries and light emitting diodes.

Silicon carbides, while regarded highly polymorphic, are generally classified into amorphous, α- and β-forms. The amorphous silicon carbides are often used in preparing heat-resistant or wear-resistant coatings. The α-silicon carbides include a number of polymorphs having a hexagonal or rhombohedral crystalline structure. Among these, 6H-SiC particularly shows a wide band gap, e.g., 2.9 eV, and thus is widely used in the manufacture of blue light emitting diodes, as well as UV detectors, high temperature electronic devices, radioactive resistant components, high power devices and high frequency circuitries. The β-silicon carbide, 3C-SiC, having a cubic crystalline structure, is similarly used in various electronic systems (see Application Notes and Catalogs, Cree Research, Inc.).

Conventionally, silicon carbide films have been prepared by employing the so-called chemical vapor deposition(CVD) method from a silicon-containing compound [e.g., silicon tetrachloride (SiCl₄), trichlorosilane(SiHCl₃) or silane(SiH₄)] and a carbon-containing compound[e.g., methane (CH₄), propane(C₃H₈) or benzene(C₆H₆)] together, or a single compound containing both silicon and carbon atoms (e.g., a chloroalkylsilane or alkylsilane). Most of these processes need a very high deposition temperature, e.g., above 1,200 °C (C. E. Morosanu, Thin Films by Chemical Vapor Deposition, Elsevier (1990); H. Matsunami, Diamond Relat. Mater. 2, 1043-1050 (1993)).

However, the processes for preparing the silicon carbide films by employing two or more source compounds at a high deposition temperature have a number of inherent deficiencies. For instance, owing to the high deposition temperature, only a limited number of materials which can withstand the high temperature may be used as a substrate in the deposition process. Further, in order to use two or more source compounds, it is necessary to precisely control the respective amounts of the source materials so as to attain the exact composition, thereby requiring the use of rather complicated apparatus.

The CVD method has been widely used to coat the surface of a certain target or substrate with specific source materials. This method comprises vaporizing the source compounds and exposing the substrate maintained at a suitable temperature to the vapor so as to cause deposition of the source compounds on the surface of the substrate, thereby forming a film thereon. For heating the substrate, resistive, high-frequency, infrared, or electron beam heating may be employed.

In addition to the conventional thermal CVD method described above, the types of CVD methods include a photo-CVD process wherein source compounds are activated by light and then deposited on the surface of a substrate; a plasma CVD technique wherein the source compounds are activated in the form of a plasma, thereby accelerating the deposition thereof on the substrate; and a laser CVD approach wherein the source compounds are decomposed or activated by a laser beam(CVD Handbook, Bando Publishing Co., 1993).

U.S. Patent No. 4,923,716 discloses the preparation of a silicon carbide film by employing a source compound containing both carbon and silicon atoms, e.g., 1,2-bissilylethane (H₃SiCH₂CH₂SiH₃), at a high temperature ranging from 1,100 to 1,400 °C. Similarly, there has been reported a process to prepare a silicon carbide film by employing 1,3-disilacyclobutane[(SiH₂CH₂)₂](D. J. Larkin and L.V. Interrante, Chem. Mater. 4, 22-24 (1992)). Despite the improvement made in these processes, however, a high temperature is still required for the deposition process.

US-A-5 053 255 discloses a thermal CVD process for the deposition of silicon carbide-type films using di-t-butylsilane. The process is carried out at about 400 to 1100°C and about 13.3 - 133 Pa. The deposition can be carried out on various substrates including silicon wafers. Silaalkane compounds having two or three silicon atoms are not mentioned or suggested in this reference.

### Summary of the Invention

Accordingly, it is a primary object of the present invention to provide a process for preparing a silicon carbide film through a chemical vapor deposition process conducted at a lower temperature by employing a linear silaalkane compound having alternating carbon and silicon atoms alone or in a mixture of two or more such silaalkane compounds as a source for the silicon and carbon atoms.

According to the present invention there is provided a chemical vapor deposition process for preparing a silicon carbide film, which comprises vaporizing at least one linear silaalkane compound having alternating carbon and silicon atoms, charging the vapor of said linear silaalkane compound into a vacuum system and exposing a substrate to the vapor to form the silicon carbide film on the surface of the substrate, characterized in that said linear silaalkane compound contains two or three silicon atoms wherein at least one of hydrogen, methyl, ethyl and propyl is bonded to each of said two or three silicon atoms and to the one or two carbon atoms, respectively, between them.

### Brief Description of the Drawing

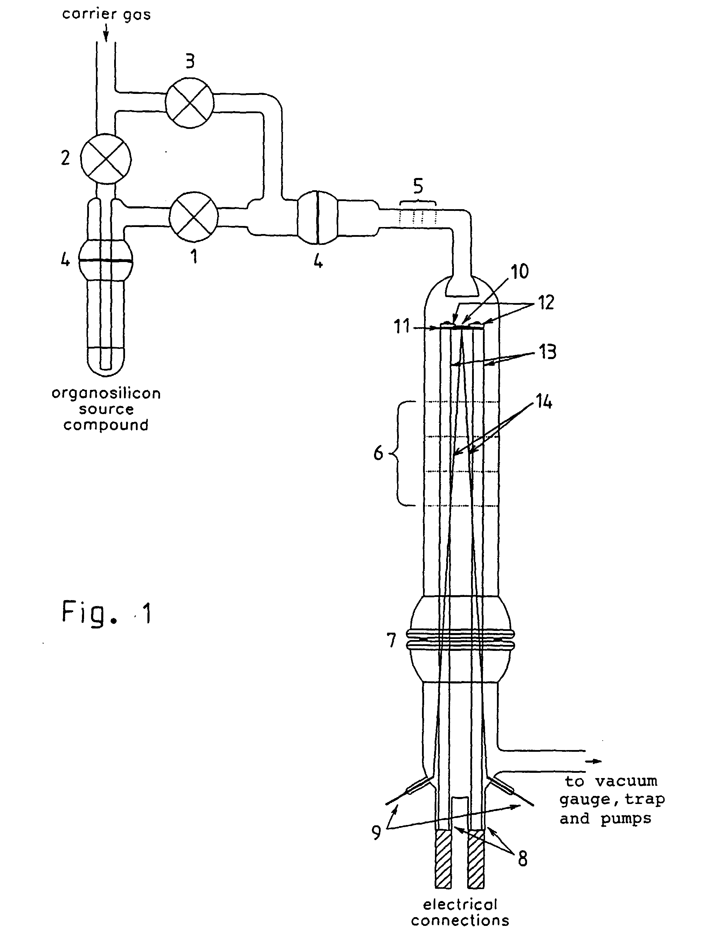

Fig. 1 shows an apparatus for preparing silicon carbide films from organosilicon compounds by the chemical vapor deposition method in accordance with the present invention.

### Detailed Description of the Invention

Linear silaalkane compounds which may be used in the present invention comprise three or two silicon atoms. In the case of the compounds containing two silicon atoms, e.g., 1,3-disilabutane (H₃SiCH₂SiH₂CH₃), at least one of hydrogen, methyl, ethyl and propyl is preferably bonded to each of the two silicon atoms and to the carbon atom between them. As for the compounds containing three silicon atoms, e.g., 1,3,5-trisilapentane(H₃SiCH₂SiH₂CH₂SiH₃), 2,4,6-trisilaheptane(H₃CSiH₂CH₂SiH₂CH₂SiH₂CH₃) and 2,6-dimethyl-2,4,6-trisilaheptane[H₃CSiH(CH₃)CH₂SiH₂CH₂SiH(CH₃)CH₃], at least one of hydrogen, methyl, ethyl and propyl is preferably bonded to each of the three silicon atoms and to the two carbon atoms between them. When any of these compounds is used, even at a temperature of below 1000 °C, the vapor deposition of silicon carbide on the surface of the substrate occurs and, in particular, in the case of using 1,3-disilabutane (H₃SiCH₂SiH₂CH₃), an amorphous silicon carbide film is deposited even at a considerably lower temperature ranging from 600 to 650 °C; and, at a temperature ranging from 750 to 800 °C, a β-silicon carbide film can be obtained.

In addition, in the case of using dimethylisopropyl-silane, films of amorphous, α- or β-silicon carbides can be formed in similar temperature ranges to those wherein said 1,3-disilabutane is used. Also, by employing trisilaalkanes containing three silicon atoms, e.g., 1,3,5-trisilapentane, 2,4,6-trisilaheptane or 2,6-dimethyl-2,4,6-trisilaheptane, β-silicon carbide films are formed at a temperature of 1,000 °C or less and, in particular, in the case of 2,4,6-trisilaheptane, α-silicon carbide films are also obtained at a similar temperature. Accordingly, these compounds have the unexpected advantage that silicon carbide films of various types can be formed at a low temperature, and, further, they are easy to handle since they are all in liquid phase.

Furthermore, since 1,3-disilabutane contains silicon and carbon atoms in the ratio of 1:1 with only hydrogen atoms as heteroatoms within the molecule and thus no impurity being released, it is particularly preferred as the source compound of silicon and carbon atoms.

On the other hand, in the case of 1,3,5-trisilapentane and 2,4,6-trisilaheptane, it can be difficult to prepare a silicon carbide film containing carbon and silicon atoms in the 1:1 ratio by employing these compounds alone, since the former contains 2:3 of carbon:silicon and the latter contains 4:3 of carbon: silicon. However, if these compounds are used in a mixture of the 1:1 molar ratio, such problem can be solved. Further, since 2,4,6-trisilaheptane and 2,6-dimethyl-2,4,6-trisilaheptane contain more carbon atoms than silicon, it is somewhat difficult to prepare good silicon carbide films from these compounds. In this case, by employing said source compounds together with hydrogen as a carrier gas, excessive carbon atoms can be removed in the form of methane, thereby forming a good silicon carbide film. In the case of dimethyl-isopropylsilane, silicon carbide films can be readily prepared without using the hydrogen carrier gas.

The silaalkane compounds which can be used in the present invention may be synthesized, for example, as follows.

Dimethylisopropylsilane (for comparison): This compound is a liquid material having the molecular weight of 102.25, density of 0.724 g/ml, boiling point of 66 to 67 °C, freezing point of -30 °C and a relatively high vapor pressure at room temperature. Advantageously, it is commercially available and relatively inexpensive. Further, dimethylisopropyl-silane can be synthesized by reacting chlorodimethylisopropylsilane, which is about 3 times lower in price than dimethylisopropylsilane, with lithium aluminium hydride or sodium hydride.

1,3-Disilabutane: An organochlorosilane represented by the following formula (1) is reacted with a metallic silicon and hydrogen chloride using copper as a catalyst and cadmium as a co-catalyst to provide a chlorodisilaalkane represented by formula (2): 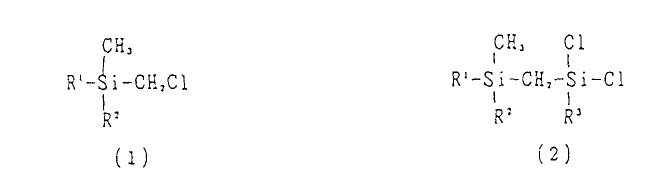 wherein:
R¹ and R² are independently a chlorine or methyl, and
R³ is a hydrogen or chlorine.
Thereafter, the resulting chlorodisilaalkane is reduced with a metal hydride, e.g., lithium aluminium hydride, to give a disilaalkane represented by formula (3): 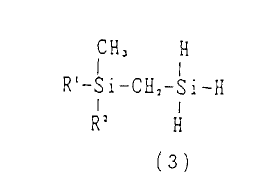 wherein:
R¹ and R² are independently a hydrogen or methyl.
When both R¹ and R² are hydrogen atoms in formula (3), the product is 1,3-disilabutane(see Korean Patent Application No. 92-4705).

1,3,5-Trisilapentane, 2,4,6-trisilaheptane and 2,6-dimethyl-2,4,6-trisilaheptane: An α-chloromethylsilane represented by the following formula (4) is directly reacted with a metallic silicon to form a chlorinated trisilaalkane represented by the formula (5) (see I.N. Jung, et al., Bull. Korean Chem. Soc. 12, 445-449 (1991)): 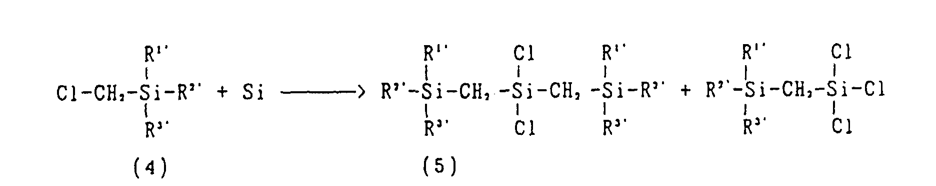 wherein:
R^{1'}, R^{2'} and R^{3'} are independently a hydrogen, methyl, ethyl or propyl.
Reduction of the compound represented by formula (5) produces a hydrogenated trisilaalkane.

In accordance with the present invention, silicon carbide is deposited on the surface of a substrate by employing any of the above-described linear silaalkane compounds to produce a chemical vapor thereof at a pressure ranging from 25 to 55 Pa and a temperature ranging from 600 to 1,000 °C. At a temperature above 750 °C, the silaalkane compound can be deposited on the surface of a substrate, such as Si(100), carbon steel, graphite or silicon carbide(single crystalline or polycrystalline), to give a β-silicon carbide film. At a temperature ranging from 600 to 650 °C, an amorphous silicon carbide film is formed, and annealing of the film at a temperature of 750 °C or higher by employing, e.g., a resistive heating can produce a β-silicon carbide film. Also, when 1,3-disilabutane is deposited on the surface of Si(111) substrate at a temperature of 750 °C or higher, epitaxial growth of a β-silicon carbide film on the substrate is observed. Particularly, in the case of using dimethylisopropylsilane, an α-silicon carbide film is formed on the surface of Si(100) at 950 °C.

On the other hand, in the case of a trisilaalkane, e.g., 1,3,5-trisilapentane, 2,4,6-trisilaheptane or 2,6-dimethyl-2,4,6-trisilaheptane, by employing one of these compounds or in a mixture of two or more with or without a carrier gas, a β-silicon carbide film may be obtained on the surface of silicon(single crystalline or polycrystalline), carbon steel, graphite or silicon carbide(single crystalline or polycrystalline). In case where 2,4,6-trisilaalkane is used, an α-silicon carbide film is obtained at a temperature of 950 °C or higher.

The carrier gas which can be used in the present invention may include hydrogen, argon or a mixed gas of hydrogen and argon in the ratio of 4:1, for example. The amount of the carrier gas which may be employed ranges from 1 to 15 sccm in the case of hydrogen, from 5 to 30 sccm in the case of argon and from 5 to 50 sccm in the case of 4:1 mixture of hydrogen and argon.

Further, by using a high-frequency heating method, dimethylisopropylsilane or 1,3-disilabutane also can be deposited on graphite, silicon carbide(polycrystalline and single crystalline) or tungsten carbide at a pressure ranging from 25 to 55 Pa and at a temperature around 680 °C to form an amorphous silicon carbide film. Furthermore, the substrate may be pretreated with a methane, ethane, propane or butane gas diluted with hydrogen to a concentration ranging from 0.1 to 0.5 % at a temperature ranging from 750 to 1,200 °C for 5 to 25 minutes to form a carbonized film on the surface of the substrate, thereby preventing the appearance of cracks on the resulting silicon carbide film.

Also, in order to remove an oxygen layer which may be formed on the surface of a substrate, the substrate may be pretreated with 25 to 100 sccm of hydrogen at a temperature ranging from 870 to 970 °C prior to the deposition of source compounds.

The organosilicon compounds which are used to prepare the silicon carbide films of the present invention are particularly preferred, since they are non-toxic liquids, easy to handle and suitable to carry out the chemical vapor deposition due to high vapor pressures thereof, and the functional groups thereof are readily removed by thermal decomposition even at a relatively low temperature, thereby preventing the incorporation thereof into the resulting silicon carbide films and forming the films having a desired composition.

The following Examples are intended to illustrate the present invention more specifically, without limiting the scope of the invention.

In the Examples, the apparatus which is used for the chemical vapor deposition is prepared by appropriately connecting Pyrex and quartz tubings, and comprises a bubbler, a reactor, a liquid nitrogen trap and a vacuum pump as major parts(See, Fig. 1). The bubbler assembly is a combination of two Pyrex O-ring joints and three stopcocks. The lower part of the bubbler is a tube having the outer diameter of 2.4 cm and length of 7 cm, which can afford about 10 ml of a liquid sample. Upon opening the stopcock A (1), the vapor of the liquid sample is diffused into the reactor. Upon opening stopcock B (2), the carrier gas can be fed to the reactor through the bubbler. Stopcock C (3) is used to purge the reactor assembly. The upper part of the reactor which is connected to one end of the bubbler through an O-ring joint (4) is a graded seal (5) made of Kimax glass and quartz. The core of the reactor is a quartz tubing connected to a quartz-to-Kimax graded seal (6) the end of which is welded to a larger Pyrex O-ring joint (7). To the lower half of this joint are welded two glass-to-metal transition tubings (8) and two thermocouple leads (9). The substrate (10) for the deposition is placed on a piece of nichrome plate (11) by a pair of copper fasteners (12) that are fixed on top of two thick copper rods (13) by stainless steel screws and heated by resistive heating of the nichrome plate. The current for heating was supplied through the two glass-to-metal transition tubings to which the lower ends of the two copper rods were welded. The temperature of the substrate was measured by a Chromel-Alumel thermocouple (14) or an optical pyrometer and the pressure in the reaction system was measured by a Convectron gauge located between the Pyrex tubing connected to the lower part of the reactor and the liquid nitrogen trap. The liquid nitrogen trap is connected to an oil diffusion pump and a rotary vane pump from which gas and vapor are exhausted to the outside through a fume hood. The vapor that reaches the liquid nitrogen trap without being deposited in the reactor is collected into the trap, and if no other byproduct is trapped therein together, the collected vapor may be recycled into the reaction system.

In the chemical vapor deposition process, all liquid samples are contained in the bubbler and used at room temperature without heating.

### Example 1 (for comparison)

2 ml of dimethylisopropylsilane was vaporized and deposited on the surface of Si(100) at 650 °C and at a pressure ranging from 25 to 55 Pa for 4 to 6 hours using the above-mentioned chemical vapor deposition apparatus to form an amorphous silicon carbide film. The resulting film was annealed at 750 °C for about 1 hour to give a β-silicon carbide film, as confirmed by an X-ray diffraction pattern. The ratio of silicon:carbon constituting the silicon carbide film, which was measured by X-ray photoelectron spectroscopy, was 1:1 within the experimental error. However, the scanning electron microscopic examination of said film showed that the surface of the silicon carbide film was not continuous, but considerably cracked.

### Example 2

A silicon carbide film was deposited on the surface of Si(100) by repeating the procedures described in Example 1 (for comparison), except using 1,3-disilabutane as a precursor for the deposition. The resulting film possessed the properties similar to those of the film prepared in Example 1, and a β-silicon carbide film thereof was obtained by annealing the resulting film at 750 °C or raising the deposition temperature to 750 - 800 °C.

### Example 3

A silicon carbide film was deposited on Si(100) by repeating the procedures described in Example 1 (for comparison), except using 2,6-dimethyl-2,4,6-trisilaheptane as a precursor. At the temperature of 700 °C or below, an amorphous silicon carbide film was produced. This film was annealed at a temperature of 750 °C or higher by using hydrogen or 4:1 mixture of hydrogen and argon to form a β-silicon carbide film.

### Example 4

The procedures described in Example 1 (for comparison) were repeated except using 2,4,6-trisilaheptane as a precursor for the deposition. In this case, a β-silicon carbide film was formed only at the relatively high temperature of 920 °C or higher. Further, with a hydrogen carrier gas, an α-silicon carbide film was produced at 950 °C or higher.

### Example 5

In this Example, the surface of a Si(100) substrate was carbonized in order to prevent the development of cracks on the surface of the resulting silicon carbide film. This process is referred to as a carbonization or carburization. After 25 to 100 sccm of hydrogen was flowed for 5 to 25 minutes onto the Si(100) substrate, which was maintained at a temperature ranging from 870 to 970 °C by resistive heating, the temperature of the substrate was raised to 1,000 - 1,200 °C and methane or propane diluted with hydrogen at a concentration ranging from 0.1 to 0.5 % was flowed onto the substrate for 5 to 25 minutes to form a carbonized film on the surface of the substrate, as confirmed by X-ray photoelectron spectroscopy. The carbonized Si(100) substrate maintained its mirror surface, but appeared dark due to the lowered gloss. The deposition of a silicon carbide film was carried out by heating the carbonized substrate to 900 °C and using a 1:1 mixture of 1,3,5-trisilapentane and 2,4,6-trisilaheptane.

The silicon carbide film prepared as above had the same composition and phase as those of the films produced in Examples 1 (for comparison) and 2 and no cracks were observed from the surface of the film. At a temperature lower than 900 °C, no β-silicon carbide film was formed.

### Example 6

2 ml of 2,6-dimethyl-2,4,6-trisilaheptane was vaporized and deposited on a carbonized Si(100) substrate at 950 °C for 4 to 6 hours. Since this compound contains silicon and carbon atoms in the ratio of 3:6 thereby probably leading to the production of a film which comprises more carbon atoms than silicon atoms, the deposition was carried out by employing hydrogen as a carrier gas. The resulting film contained 1:1 ratio of silicon and carbon, and as confirmed by an X-ray diffraction pattern, the β-silicon carbide film was formed.

### Example 7

The procedures described in Example 6 were repeated except using 1,3-disilabutane at 850 °C. The resulting film contained 1:1 ratio of carbon and silicon and the film surface was crack-free. The X-ray diffraction pattern thereof showed a reduced number of characteristic silicon carbide peaks; however, the epitaxial growth of silicon carbide was not achieved. Further, it was difficult to identify the boundary between the film and the substrate from the scanning electron microscopy image of the cross-section thereof. This may be caused by an initial formation of carbide on the surface of the substrate during carbonization.

### Example 8 (for comparison)

2 ml of dimethylisopropylsilane was vaporized and deposited at 970 to 1,000 °C on a Si(100) substrate which was pretreated with hydrogen at 970 °C for 15 minutes and carbonized at 1,190 °C for 5 minutes. The resulting film had 1:1 ratio of silicon and carbon and its X-ray diffraction pattern showed that a β-silicon carbide film was formed. However, at a temperature of 950 °C or below, the formation of an α-silicon carbide film was observed.

### Example 9

By using 2 ml of 2,4,6-trisilaheptane, a silicon carbide film was deposited at 920 to 970 °C on a Si(100) substrate treated as in Example 8 (for comparison). The resulting film had about 1:1 ratio of silicon and carbon. The X-ray diffraction pattern showed that only α-silicon carbide film was formed independently of the deposition temperature. This indicates that α-silicon carbide films can be formed on a carbonized Si(100) substrate without using hydrogen as a carrier gas.

### Example 10

2 ml of 1,3-disilabutane was vaporized and deposited on a Si(111) substrate at various temperatures ranging from 650 to 900 °C for 4 to 6 hours. As a result, an amorphous film was formed at 750 °C or below on the non-carbonized Si(111) substrate, and a β-phase film was formed thereon at a temperature greater than 750 °C. In the case of using a Si(111) substrate carbonized at 1,160 °C for 5 minutes, a β-phase film was apparently formed at 900 °C as in Example 7. The X-ray diffraction pattern thereof showed only SiC(111) peak, thereby suggesting that the epitaxial growth of silicon carbide was achieved.

### Example 11

A quartz tubing was charged with a 3 cm x 3 cm x 1 cm graphite plate, which is often used as a susceptor in the chemical vapor deposition process, and heated to about 700 °C by a high frequency of 58 kHz and 800 W. To this tubing was flowed a vapor of 1,3-disilabutane to deposit a silicon carbide film on the graphite substrate. The resulting film was confirmed to be amorphous by its X-ray diffraction pattern and contained about 1:1 ratio of carbon and silicon.

### Example 12 (for comparison)

A 1.2 cm x 1.2 cm x 0.3 cm tungsten carbide plate was placed on the graphite susceptor and heated by a high frequency of 58 kHz and 700 W to maintain the temperature at 680 °C. Onto this was flowed a vapor of dimethylisopropylsilane to deposit a silicon carbide film on the tungsten carbide substrate. The resulting film was confirmed to be amorphous by its X-ray diffraction pattern and contained about 1:1 ratio of carbon and silicon.

### Example 13

A 1.2 cm x 1.2 cm x 0.1 cm plate of sintered silicon carbide was placed on the graphite susceptor and heated by a high frequency of 58 kHz and 700 W to maintain the temperature at 680 °C. Onto this was flowed a vapor of dimethylisopropyl-silane to deposit a silicon carbide film. The resulting film was confirmed to be amorphous by its X-ray diffraction pattern and contained about 1:1 ratio of carbon and silicon.

As described above, in accordance with the present invention, silicon carbide films can be prepared from organosilicon compounds alone containing both carbon and silicon by a chemical vapor deposition at low temperatures.

While the invention has been described in connection with the above specific embodiments, it should be recognized that various modifications and changes may be made within the scope of the invention as defined by the claims that follow.

## Claims

1. A chemical vapor deposition process for preparing a silicon carbide film, which comprises vaporizing at least one linear silaalkane compound having alternating carbon and silicon atoms, charging the vapor of said linear silaalkane compound into a vacuum system and exposing a substrate to the vapor to form the silicon carbide film on the surface of the substrate, characterized in that said linear silaalkane compound contains two or three silicon atoms wherein at least one of hydrogen, methyl, ethyl and propyl is bonded to each of said two or three silicon atoms and to the one or two carbon atoms, respectively, between them.

2. The process of claim 1, wherein the linear silaalkane compound is selected from the group consisting of 1,3-disilabutane, 1,3,5-trisilapentane, 2,4,6-trisilaheptane and 2,6-dimethyl-2,4,6-trisilaheptane.

3. The process of claim 1, wherein the process is conducted at a pressure of the vapor ranging from 25 to 55 Pa, and at a temperature of the substrate ranging from 600 to 1,000 °C.

4. The process of claim 1, wherein the substrate is pretreated with 25 to 100 sccm of hydrogen at a temperature ranging from 870 to 970 °C to remove oxygen from the surface of the substrate prior to the deposition of the silicon carbide film.

5. The process of claim 1, wherein the linear silaalkane compound is used in admixture with a carrier gas.

6. The process of claim 5, wherein the carrier gas is hydrogen, argon or a mixture thereof.

7. The process of claim 1, wherein the surface of the silicon substrate is carbonized with methane, ethane, propane or butane prior to the deposition of the silicon carbide film.

8. The process of claim 1, wherein the substrate is selected from the group consisting of polycrystalline silicon, single crystalline silicon, graphite, polycrystalline silicon carbide, single crystalline silicon carbide, tungsten carbide and carbon steel.

## Patentansprüche

1. Chemisches Dampfabscheidungsverfahren zur Herstellung eines Siliciumcarbid-Filmes, welches umfaßt, daß man mindestens eine lineare Silaalkan-Verbindung mit alternierenden Kohlenstoff- und Siliciumatomen verdampft, den Dampf der linearen Silaalkan-Verbindung in ein Vakuumsystem einführt und ein Substrat dem Dampf aussetzt, um den Siliciumcarbid-Film auf der Oberfläche des Substrats zu bilden, dadurch gekennzeichnet, daß die lineare Silaalkan-Verbindung zwei oder drei Siliciumatome enthält, wobei mindestens eines aus Wasserstoff, Methyl, Ethyl und Propyl an jedes der zwei oder drei Siliciumatome und. an das eine bzw. die zwei Kohlenstoffatome zwischen diesen gebunden ist.

2. Verfahren nach Anspruch 1, in welchem die lineare Silaalkan-Verbindung aus der Gruppe ausgewählt ist, die aus 1,3-Disilabutan, 1,3,5-Trisilapentan, 2,4,6-Trisilaheptan und 2,6-Dimethyl-2,4,6-trisilaheptan besteht.

3. Verfahren nach Anspruch 1, in welchem das Verfahren bei einem Druck des Dampfes im Bereich von 25 bis 55 Pa und bei einer Temperatur des Substrats im Bereich von 600 bis 1000°C durchgeführt wird.

4. Verfahren nach Anspruch 1, in welchem das Substrat mit 25 bis 100 Scm³ (sccm) Wasserstoff bei einer Temperatur im Bereich von 870 bis 970°C vorbehandelt wird, um vor der Abscheidung des Siliciumcarbid-Filmes Sauerstoff von der Oberfläche des Substrats zu entfernen.

5. Verfahren nach Anspruch 1, in welchem die lineare Silaalkan-Verbindung in Mischung mit einem Trägergas verwendet wird.

6. Verfahren nach Anspruch 5, in welchem das Trägergas Wasserstoff, Argon oder eine Mischung derselben ist.

7. Verfahren nach Anspruch 1, in welchem die Oberfläche des Silicium-Substrats vor der Abscheidung des Siliciumcarbid-Filmes mit Methan, Ethan, Propan oder Butan carbonisiert wird.

8. Verfahren nach Anspruch 1, in welchem das Substrat aus der Gruppe ausgewählt ist, die aus polykristallinem Silicium, einkristallinem Silicium, Graphit, polykristallinem Siliciumcarbid, einkristallinem Siliciumcarbid, Wolframcarbid und Kohlenstoffstahl besteht.

## Revendications

1. Procédé de dépôt chimique en phase vapeur pour préparer un film de carbure de silicium, qui comprend la vaporisation d'au moins un composé silaalcane linéaire ayant des atomes de carbone et de silicium en alternance, le chargement de la vapeur dudit composé silaalcane linéaire dans un système sous vide et l'exposition d'un substrat à la vapeur pour former le film de carbure de silicium sur la surface du substrat, caractérisé en ce que ledit composé silaalcane linéaire contient deux ou trois atomes de silicium dans lequel au moins un atome d'hydrogène, un groupe méthyle, éthyle ou propyle est lié à chacun desdits deux ou trois atomes de silicium et à l'un ou aux deux atomes de carbone, respectivement placés entre eux.

2. Procédé selon la revendication 1, dans lequel le composé silaalcane linéaire est choisi parmi le 1,3-disilabutane, le 1,3,5-trisilapentane, le 2,4,6-trisilaheptane et le 2,6-diméthyl-2,4,6-trisilaheptane.

3. Procédé selon la revendication 1, dans lequel le procédé est réalisé à une pression de la vapeur dans la gamme de 25 à 55 Pa, et à une température du substrat dans la gamme de 600 à 1000°C.

4. Procédé selon la revendication 1, dans lequel le substrat est prétraité avec un débit de 25 à 100 Ncm³/min d'hydrogène à une température dans la gamme de 870 à 970°C pour éliminer l'oxygène de la surface du substrat avant le dépôt du film de carbure de silicium.

5. Procédé selon la revendication 1, dans lequel on utilise le composé cycloalcane linéaire en mélange avec un gaz porteur.

6. Procédé selon la revendication 5, dans lequel le gaz porteur est l'hydrogène, l'argon ou un mélange de ceux-ci.

7. Procédé selon la revendication 1, dans lequel la surface du substrat de silicium est carbonisée avec du méthane, de l'éthane, du propane ou du butane avant le dépôt du film de carbure de silicium.

8. Procédé selon la revendication 1, dans lequel le substrat est choisi parmi le silicium polycristallin, le silicium monocristallin, le graphite, le carbure de silicium polycristallin, le carbure de silicium monocristallin, le carbure de tungstène et l'acier au carbone.
